# EUROPEAN PATENT APPLICATION

(11) **EP 4 769 481 A1**
(43) Date of publication of application: **01.07.2026**
(21) Application number: 24856224.1
(22) Date of filing: 30.07.2024
(51) Int. Cl.: H01L 21/205, C30B 29/06

(54) **METHOD FOR MANUFACTURING EPITAXIAL WAFER**

(30) Priority: 21.08.2023 JP 2023133853
(71) Applicant: Shin-Etsu Handotai Co., Ltd., Tokyo 100-0004 (JP)
(72) Inventor: SUZUKI, Katsuyoshi, Annaka-shi, Gunma 379-0196 (JP); FUJII, Kota, Nishishirakawa-gun, Fukushima 961-8061 (JP); OHTSUKI, Tsuyoshi, Nishishirakawa-gun, Fukushima 961-8061 (JP); SUZUKI, Atsushi, Nishishirakawa-gun, Fukushima 961-8061 (JP)
(74) Representative: Schicker, Silvia
(86) International application number: PCT/JP2024/027052
(87) International publication number: WO 2025/041531

(57) **Abstract**

The present invention is a method for manufacturing an epitaxial wafer by forming a single-crystal silicon layer on a single-crystal silicon wafer via an oxygen-atom layer, the method including the steps of removing a native oxide film, forming a thermal oxide film on a surface of the single-crystal silicon wafer from which the native oxide film has been removed, thinning the thermal oxide film, and after thinning the thermal oxide film, epitaxially growing single-crystal silicon to form an epitaxial wafer in which the single-crystal silicon layer is formed on the single-crystal silicon wafer via the oxygen-atom layer. This provides the method for manufacturing an epitaxial wafer, in which, when manufacturing a silicon epitaxial wafer, the oxygen-atom layer can be introduced into an epitaxial layer stably and easily.

## Description

### TECHNICAL FIELD

The present invention relates to a method for manufacturing an epitaxial wafer.

### BACKGROUND ART

Silicon substrates on which semiconductor devices, such as solid-state imaging sensors and other transistors, are formed are required to have a function of gettering elements that adversely affect device characteristics, such as heavy metals. As gettering, various methods have been proposed and put into practical use, such as a polycrystalline silicon (Poly-Si) layer provided on the back surface of the silicon substrate, forming a layer damaged by blasting treatment, a silicon substrate with a high concentration of boron, or forming precipitates. In gettering by oxygen precipitation, gettering is performed by incorporating a metal having a high ionization tendency (low electronegativity) with respect to oxygen, which has high electronegativity.

Moreover, so-called proximity gettering, in which a gettering layer is formed in the vicinity of the active region of the device, has been proposed. An example includes a substrate in which carbon is ion-implanted into a substrate, and silicon is epitaxially grown on this substrate. In gettering, the elements are required to diffuse to gettering sites (the energy of the entire system is lowered by bonding or clustering of the metal at the above sites, as compared with the case where the metal exists as a single element). In consideration of the fact that the diffusion coefficients of metal elements contained in silicon differ depending on the element, and that the metals are unable to diffuse to the gettering sites due to the recent decrease in process temperature, a proximity gettering method has been proposed.

It is considered that when oxygen can be used for proximity gettering, a silicon substrate having a highly effective gettering layer can be obtained. In particular, when an epitaxial wafer has an oxygen-atom layer in the middle of an epitaxial layer, metal impurities can be reliably subjected to gettering even in recent low-temperature processes. In addition to the gettering, effects of suppressing the diffusion of dopants such as boron and phosphorus are expected.

As described above, the epitaxial wafer, particularly having an oxygen-atom layer in the middle of the epitaxial layer, can improve device performance more than a conventional epitaxial wafer having no oxygen-atom layer.

Subsequently, the prior arts will be described. Patent Document 1 discloses a method including performing the step of removing a native oxide film on a silicon wafer surface at 700°C or less, and subsequently, one or more times, performing the step of forming an oxygen-atom layer and a single-crystal silicon layer, in which the oxygen-atom layer having a planar density of 1×10¹⁵ atoms/cm² or less is formed on the single-crystal silicon wafer surface using nitric oxide, and the single-crystal silicon layer is epitaxially grown thereon.

Patent Document 2 discloses a method including removing a native oxide film on a surface of a wafer composed of Group IV elements containing silicon in an atmosphere containing hydrogen, then oxidizing the wafer surface to form an oxygen-atom layer, and further epitaxially growing a single-crystal silicon layer on the top of the structure.

Patent Document 3 discloses a method including removing a native oxide film from a single-crystal silicon wafer surface using hydrofluoric acid, subsequently rinsing the wafer with pure water or leaving the wafer in an oxygen-containing atmosphere to form an oxygen-atom layer, and then epitaxially growing a single-crystal silicon layer thereon.

Patent Document 4 discloses a method including forming an oxide film on a silicon substrate using an oxidizing aqueous solution, and then epitaxially growing a semiconductor single-crystal layer on the oxide film.

Patent Document 5 discloses a method for forming an epitaxial layer using SiH₄ gas on an atomic layer, such as oxygen, having a thickness of 5 nm or less. This patent document also discloses a method for forming an oxygen-atom layer using oxygen gas.

Patent Document 6 discloses a method for forming a silicon epitaxial layer, after forming an oxygen-inserted partial monolayer by supplying an oxygen-containing precursor to a CVD epitaxy furnace.

### CITATION LIST

### PATENT LITERATURE

Patent Document 1: JP 2022-146664 A
Patent Document 2: JP 2021-111696 A
Patent Document 3: WO 2022/158148 A1
Patent Document 4: JP 2009-016637 A
Patent Document 5: JP 2019-004050 A
Patent Document 6: JP 2022-22194 A

### SUMMARY OF INVENTION

### TECHNICAL PROBLEM

As described above, a method has been conventionally employed in which an oxygen layer is formed in a wafer, thereby gettering a metal impurity in the wafer. However, a conventional technique, while capable of obtaining a thin oxygen layer with high precision, has problems such as the necessity of special gases or extended forming steps.

The technique disclosed in Patent Document 1 has a problem requiring a special gas, namely nitrogen monoxide.

Techniques disclosed in Patent Documents 2 and 3 have a problem requiring long-time oxidation to form an oxygen-atom layer. In addition, the technique disclosed in Patent Document 2 has a problem that it is difficult to achieve a uniform oxygen concentration in a wafer surface.

Techniques disclosed in Patent Documents 5 and 6 have problems requiring specialized apparatus, such as divided exhaust systems or robust interlocks to prevent SiH₄ and oxygen from reacting with each other and causing an explosion.

Moreover, Patent Document 4 has a problem in which no specific description is provided for forming an epitaxial layer composed of single-crystal silicon without generating dislocations and stacking faults.

As described above, the conventional techniques, while capable of obtaining an oxygen-atom layer with high precision, have problems, such as complex apparatus configuration, unstable oxygen layer introduction, and inability to obtain a high-quality epitaxial layer composed of single-crystal silicon.

The present invention has been made to solve the above-described problem. An object of the present invention is to provide a method for manufacturing an epitaxial wafer, in which, when manufacturing a silicon epitaxial wafer, an oxygen-atom layer can be introduced into an epitaxial layer stably and easily.

### SOLUTION TO PROBLEM

To achieve the object, the present invention provides a method for manufacturing an epitaxial wafer by forming a single-crystal silicon layer on a single-crystal silicon wafer via an oxygen-atom layer, the method comprising the steps of:
removing a native oxide film from a surface of the single-crystal silicon wafer;
forming a thermal oxide film on the surface of the single-crystal silicon wafer from which the native oxide film has been removed;
thinning the thermal oxide film; and
after thinning the thermal oxide film, epitaxially growing single-crystal silicon to form an epitaxial wafer in which the single-crystal silicon layer is formed on the single-crystal silicon wafer via the oxygen-atom layer.

By employing such a method for manufacturing an epitaxial wafer, single-crystal silicon can be grown, while leaving the oxygen-atom layer intact, on the surface of the single-crystal silicon wafer having the oxygen-atom layer without forming a dislocation or a stacking fault. That is, the inventive method for manufacturing an epitaxial wafer enables a stable and easy introduction of the oxygen-atom layer into an epitaxial layer, and the manufacture of the epitaxial wafer having the epitaxial layer composed of a high-quality single-crystal silicon.

In this case, the removal of the native oxide film can be performed with a solution containing hydrofluoric acid.

In this way, by removing the native oxide film using the solution containing hydrofluoric acid, the native oxide film can be removed in a short time.

Moreover, the thermal oxide film can be formed by heat treatment in an oxygen-containing atmosphere at a temperature of 600°C or more and 1200°C or less.

Under such forming conditions of the thermal oxide film, the thermal oxide film can be stably and reliably formed.

Moreover, a value of an oxide film thickness obtained as a result of performing a spectroscopic ellipsometry measurement on the single-crystal silicon wafer from which the native oxide film has been removed is defined as "α", and a thickness of the thermal oxide film can be a thickness more than α+0.5 (nm).

By setting the thickness of the thermal oxide film in this manner, the oxide film can be formed with good reproducibility and stability.

Moreover, the removal of the native oxide film and the thinning of the thermal oxide film can be performed by heating the single-crystal silicon wafer in a hydrogen atmosphere.

By performing heating in the hydrogen atmosphere, a portion of the oxide film can be stably reduced, thereby enabling more stable removal of the native oxide film and thinning of the thermal oxide film.

In this case, a temperature of the heating in the hydrogen atmosphere can be 800°C or more and 1250°C or less.

By setting the temperature within such a range, a portion of the oxide film can be reliably reduced, thereby enabling the more stable removal of the native oxide film and thinning of the thermal oxide film.

Moreover, the removal of the native oxide film and the thinning of the thermal oxide film can be performed with plasma using a gas containing a hydrogen atom or with plasma using an inert gas.

Such plasma using the gas containing the hydrogen atom can stably reduce a part of the oxide film at a low temperature, thereby enabling more effective and stable removal of the native oxide film and thinning of the thermal oxide film. In addition, such plasma, using an inert gas, performs sputtering of the oxide film by high-energy particles generated in the plasma, thereby enabling more effective and stable removal of the native oxide film and thinning of the thermal oxide film.

Moreover, a value of an oxide film thickness obtained as a result of performing a spectroscopic ellipsometry measurement on the single-crystal silicon wafer from which the native oxide film has been removed is defined as "α", and in the step of thinning the thermal oxide film, a value of the oxide film thickness measured by spectroscopic ellipsometry after thinning can be more than the "α" and α+0.5 (nm) or less.

By setting the thickness within such a range, it is possible to prevent the epitaxial layer from becoming polycrystalline or amorphous.

Moreover, in the step of epitaxially growing single-crystal silicon, the single-crystal silicon can be epitaxially grown at a temperature of 450°C or more and 800°C or less.

By performing epitaxial growth within such a temperature range, it is possible to prevent the formation of the dislocation and the stacking fault in the formed epitaxial layer, thereby enabling the formation of a high-quality epitaxial layer with higher stability.

Moreover, after the step of epitaxially growing, CMP processing can be performed.

As a result, a surface quality of the epitaxial wafer after film formation can be improved.

Moreover, following the step of epitaxially growing single-crystal silicon, the step of forming a thermal oxide film, the step of thinning the thermal oxide film, and the step of epitaxially growing single-crystal silicon can be repeatedly performed.

By forming a plurality of oxygen-atom layers in this way, a gettering effect can be enhanced compared with a case of a single layer.

### ADVANTAGEOUS EFFECTS OF INVENTION

As described above, according to the inventive method for manufacturing an epitaxial wafer, in a silicon epitaxial wafer employed in a cutting-edge device, the oxygen-atom layer can be introduced stably and easily into the epitaxial layer without using a specialized apparatus, and the epitaxial wafer having the epitaxial layer composed of high-quality single-crystal silicon can be manufactured. Moreover, it becomes possible to produce a proximity gettering substrate having a proximity gettering effect due to the oxygen-atom layer.

### BRIEF DESCRIPTION OF DRAWINGS

[FIG. 1] is a view showing a flowchart of a method for manufacturing an epitaxial wafer according to the present invention.
[FIG. 2] is a schematic cross-sectional view illustrating an example of an epitaxial wafer manufacturable by a method for manufacturing an epitaxial wafer according to the present invention.
[FIG. 3] is a schematic cross-sectional view illustrating another example of an epitaxial wafer manufacturable by a method for manufacturing an epitaxial wafer according to the present invention.
[FIG. 4] is a graph showing a relation between heating time and oxide film thicknesses in a hydrogen atmosphere in Example 1 and Comparative Example 1.
[FIG. 5] is a graph showing a distribution of an oxide film thickness on substrate surfaces of an epitaxial wafer after heating for 120 seconds in Example 1 and of an epitaxial wafer in Comparative Example 2.

### DESCRIPTION OF EMBODIMENTS

Hereinafter, the present invention will be described in detail. However, the present invention is not limited thereto.

In the present invention, an oxygen-atom layer is defined as a layered structure in which an oxygen atom is introduced into a Si-Si bond. The structure may have SiO₂ clusters discretely distributed in a planar manner. Note that in single-crystal silicon, the oxygen atom becomes stable at a bond center position between a silicon atom and the nearest silicon atom. Accordingly, when one atomic layer of oxygen is present, a planar density of oxygen is 1.36×10¹⁵ atoms/cm². A planar density of oxygen of 1×10¹⁵ atoms/cm² corresponds to 0.74 atomic layers.

As described above, a method for manufacturing an epitaxial wafer has been desired, in which the oxygen-atom layer can be introduced stably and easily into an epitaxial layer without requiring a specialized apparatus, and the epitaxial wafer having the epitaxial layer composed of high-quality single-crystal silicon can be manufactured.

To solve the above problem, the present inventors have earnestly studied and found that by a method for manufacturing an epitaxial wafer by forming a single-crystal silicon layer on a single-crystal silicon wafer via an oxygen-atom layer, the method including the steps of: removing a native oxide film from a surface of the single-crystal silicon wafer; forming a thermal oxide film on the surface of the single-crystal silicon wafer from which the native oxide film has been removed; thinning the thermal oxide film; and after thinning the thermal oxide film, epitaxially growing single-crystal silicon to form an epitaxial wafer in which the single-crystal silicon layer is formed on the single-crystal silicon wafer via the oxygen-atom layer, in a silicon epitaxial wafer employed in a cutting-edge device, this method enables a stable and easy introduction of the oxygen-atom layer into the epitaxial layer without using a specialized apparatus and permits the manufacture of the epitaxial wafer having the epitaxial layer composed of high-quality single-crystal silicon. This finding has led to the completion of the present invention.

### [Epitaxial Wafer]

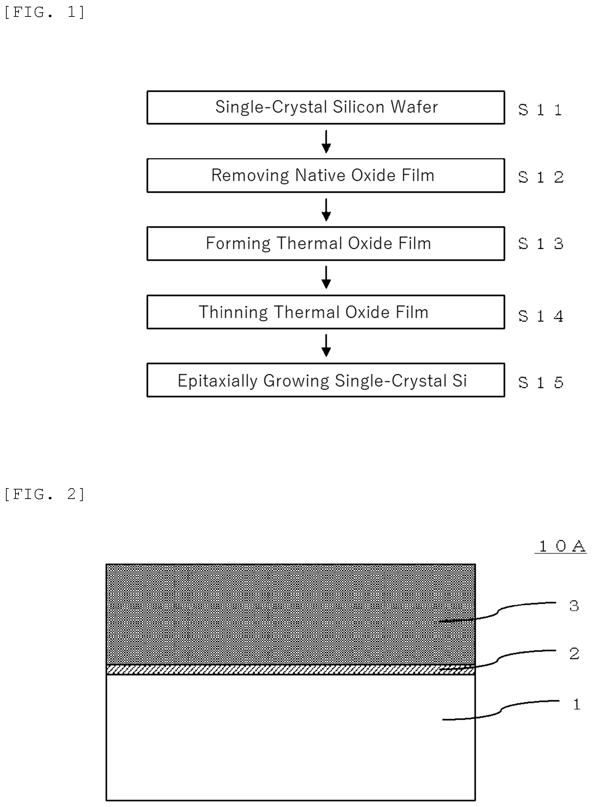

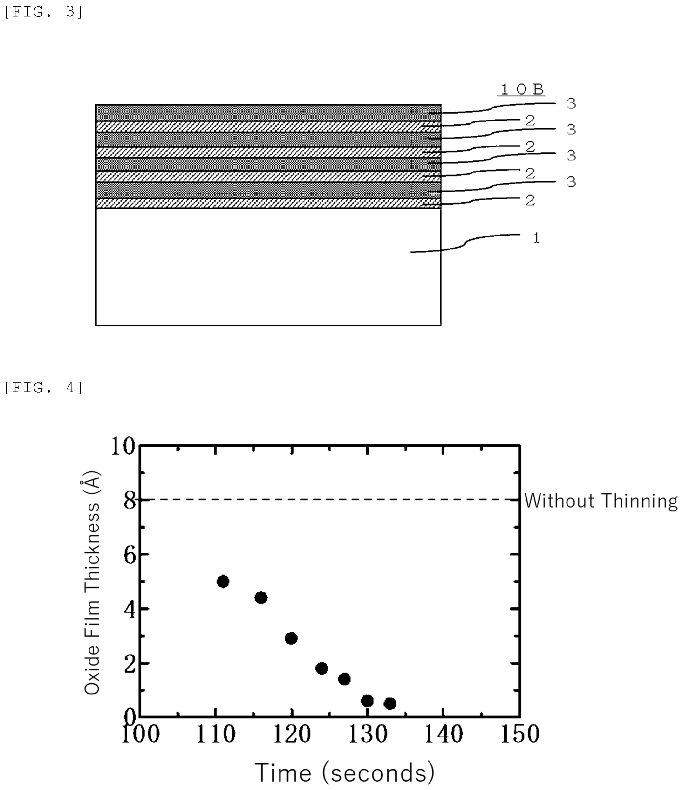

Hereinafter, the epitaxial wafer obtained by the inventive method for manufacturing an epitaxial wafer will be described with reference to FIGs. 2 and 3. As shown in FIG. 2, an epitaxial wafer 10A according to the present invention includes a single-crystal silicon layer 3 on a single-crystal silicon wafer 1, and an oxygen-atom layer 2 between the single-crystal silicon layer 3 and the single-crystal silicon wafer 1.

FIG. 3 shows an example of another epitaxial wafer according to the present invention. As shown in FIG. 3, an example of another epitaxial wafer 10B according to the present invention includes a plurality of alternating layers of the oxygen-atom layer 2 and the single-crystal silicon layer 3, on the single-crystal silicon wafer 1. The uppermost layer is the single-crystal silicon layer 3.

In this way, the presence of a plurality of the oxygen-atom layers 2 enhances a gettering effect compared to an epitaxial wafer having the oxygen-atom layer 2 composed of a single layer.

### [Method for Manufacturing Epitaxial Wafer]

Next, the inventive method for manufacturing an epitaxial wafer will be described with reference to FIG. 1. FIG. 1 shows a flowchart of the production of the epitaxial wafer having the oxygen-atom layer according to the present invention.

Step S11 in FIG. 1 is the step of providing a single-crystal silicon wafer.

A method for manufacturing a single-crystal silicon wafer that is employed as a substrate is not particularly limited. A single-crystal silicon wafer manufactured by the Czochralski method (Czochralski Method: hereinafter, referred to as "CZ method") may be employed, or a single-crystal silicon wafer manufactured by the floating zone Method (Floating Zone Method: hereinafter referred to as "FZ method") may be employed. In addition, an epitaxial wafer may be employed, in which single-crystal silicon is epitaxially grown on the single-crystal silicon wafer manufactured by the CZ method or the FZ method.

Step S12 in FIG. 1 is the step of removing a native oxide film from the surface of the single-crystal silicon wafer provided in Step S11.

The native oxide film has varied film qualities depending on the forming methods; consequently, the removal of the native oxide film is required to stably perform the thinning in Step S14.

For example, the removal of the native oxide film can be performed using a solution containing hydrofluoric acid (hydrofluoric acid). In this way, by using the solution containing hydrofluoric acid, the native oxide film can be removed in a short time.

In Step S12 for removing the native oxide film, for example, hydrofluoric acid may be used, or buffered hydrofluoric acid may be used. Buffered hydrofluoric acid is a solution prepared by mixing hydrofluoric acid and ammonium fluoride. A concentration of hydrofluoric acid in the solution containing hydrofluoric acid may be any concentration sufficient to remove the native oxide film, and can be, for example, 0.001% or more and 60% or less. The temperature of the solution containing hydrofluoric acid can be, for example, 10°C or more and 50°C or less. When the temperature is set to 10°C or more, the condensation on the wafer can be prevented after treatment using the solution containing hydrofluoric acid. In addition, when the temperature is set to 50°C or less, the amount of the volatilized hydrofluoric acid can be suppressed, and safety issues can thereby be avoided.

Cleaning time using the solution containing hydrofluoric acid (for removing the native oxide film) can be set to continue, for example, until water repellency is confirmed, and can be set to 1 second or more and 1 hour or less. When the cleaning time is set to 1 second or more, the native oxide film can be removed in a stable manner. Moreover, by setting the cleaning time to 1 hour or less, excessive cleaning time can be prevented.

The cleaning using the solution containing hydrofluoric acid (for removing the native oxide film) may be performed using either a batch cleaning apparatus or a single-wafer cleaning apparatus.

Meanwhile, in Step S12, the native oxide film may be removed using the vapor of the solution containing hydrofluoric acid.

Moreover, the native oxide film can be removed by heating the single-crystal silicon wafer in a hydrogen atmosphere. By heating in the hydrogen atmosphere, the oxide film can be stably reduced or etched, thereby enabling further stable removal of the native oxide film.

In this case, it is preferable to heat the single-crystal silicon wafer to a temperature of 800°C or more and 1250°C or less. Such a temperature range enables reliable reduction or etching of the oxide film, and thus, the native oxide film can be removed in a more stable manner. Moreover, it is more preferable that the native oxide film is removed by maintaining the temperature within this range for 1 second or more and 5 minutes or less.

A vertical furnace or a horizontal furnace may be employed as a heating apparatus, and an RTA (Rapid Thermal Annealing) apparatus may also be employed therefor.

Moreover, the removal of the native oxide film can be performed with plasma using a gas containing a hydrogen atom or plasma using an inert gas. When the plasma using the gas containing the hydrogen atom is employed, the oxide film can be stably reduced or etched at a low temperature, thereby enabling more effective and stable removal of the native oxide film. In addition, when plasma using the inert gas is employed, the native oxide film can be more effectively and stably removed by sputtering the oxide film with high-energy particles generated by the plasma.

Examples of such gases, which can be used, include a hydrogen molecule, ammonia, nitrogen, argon, helium, neon, krypton, and xenon. These gases can be mixed for use. In the case of gases containing the hydrogen atom, such as the hydrogen molecule and ammonia, the native oxide film can be removed by a hydrogen radical generated by plasma. In the case of inert gases, such as nitrogen, argon, helium, neon, krypton, and xenon, the native oxide film can be removed by sputtering with high-energy particles generated by plasma.

Note that, when the native oxide film is removed by using plasma as described above, the native oxide film may be removed at room temperature, or the native oxide film may be removed by heating at a temperature of 500°C or less. Time during which the wafer is exposed to plasma depends on plasma density, ion energy, or the like, but the native oxide film can be stably removed by setting the exposure time to, for example, 1 second or more and 30 minutes or less.

Step S13 in FIG. 1 is the step of forming a thermal oxide film on the surface of the single-crystal silicon wafer from which the native oxide film has been removed in Step S12.

It is preferable that the thermal oxide film is formed by heat-treating the single-crystal silicon wafer in an oxygen-containing atmosphere at a temperature of 600°C or more and 1200°C or less. Under such formation conditions, the thermal oxide film can be stably and reliably formed. It is more preferable that the thermal oxide film is formed by maintaining the temperature within this range for 1 second or more and 30 minutes or less.

The oxygen-containing atmosphere may be an atmosphere composed of 100% oxygen, or a gas in which oxygen is added to rare gases such as helium, neon, argon, krypton, and xenon, or nitrogen.

The vertical furnace or the horizontal furnace may be employed as the heating apparatus, and the RTA (Rapid Thermal Annealing) apparatus may also be employed therefor. By separating a thermal oxidation apparatus from a film-forming apparatus, it is possible to reliably prevent mixing of SiH₄ and oxygen and an explosion thereof. Accordingly, the epitaxial wafer having the oxygen-atom layer can be safely manufactured. Moreover, the thermal oxide film is not grown during transfer from the thermal oxidation apparatus to the film forming apparatus; consequently, the separation of the thermal oxidation apparatus and the film forming apparatus provides no issues.

After the formation of the thermal oxide film, an oxide film thickness can be measured by spectroscopic ellipsometry. A relation between oxidation heat treatment conditions and the thermal oxide film thickness may be determined in advance.

Spectroscopic ellipsometry is a technique to measure a thickness and refractive index of a thin film by measuring a change in a polarization state between incident light and reflected light on a sample. Dielectric function of the thin film is modeled, and a change in the state of polarization is then calculated using the dielectric function, thereby determining the film thickness and the refractive index. Consequently, due to insufficient accuracy in modelling, or the like, the film thickness optically determined by spectroscopic ellipsometry may not match the film thickness physically measured by TEM (Transmission Electron Microscope) or SEM (Scanning Electron Microscope). In particular, when the native oxide film is completely removed, and then the oxide film thickness is measured by spectroscopic ellipsometry, the film thickness is theoretically supposed to be 0; however, a value "α", which is larger than 0, is outputted. This "α" is influenced by surface roughness of a substrate, the removal method of a native oxide film, measurement environment, and the like. On the other hand, even when the atomic layer of oxygen has one or fewer atomic layers, a strong positive correlation is observed between the film thickness measured by spectroscopic ellipsometry and a planar density of oxygen in the oxygen-atom layer measured by SIMS (Secondary Ion Mass Spectrometry) after silicon is formed on the oxygen-atom layer. As a result, the oxide film thickness measured by spectroscopic ellipsometry can be used to estimate the required amount of oxide film to be removed for thinning the oxide film until this film corresponds to the oxygen-atom layer.

Defined the value of the oxide film thickness obtained from the result of the spectroscopic ellipsometry measurement on the single-crystal silicon wafer from which the native oxide film has been removed as "α" (nm) ("α" may also be referred to as "offset"), it is preferable that the thickness of the thermal oxide film be greater than a thickness of α+0.5 (nm) [10α+5 (Å)]. By setting such a thickness, the thermal oxide film can be formed more stably and with improved reproducibility. The upper limit of the thickness is not particularly limited, but can be α+2 (nm) [10α+20 (Å)].

Note that "α" is the value of the oxide film thickness obtained by the spectroscopic ellipsometry measurement when the oxide film is absent, as a result of measuring the oxide film thickness by spectroscopic ellipsometry after removing the native oxide film from the single-crystal silicon wafer. By subtracting "α" from the value obtained from the measurement of the film thickness of the oxide film, which is actually formed, by spectroscopic ellipsometry, an actual film thickness of the oxide film can be determined.

Step S14 in FIG. 1 is the step of thinning the thermal oxide film formed in Step S13.

By forming the oxide film to a thickness greater than the intended thickness of the oxygen-atom layer and then thinning the oxide film, it is possible to stably form the oxygen-atom layer with better controllability. This is because subsequent oxidation has a slower oxidation rate and better controllability compared to that of initial oxidation.

It is possible to perform thinning of the thermal oxide film by heating the single-crystal silicon wafer in a hydrogen atmosphere. By heating in a hydrogen atmosphere, a portion of the oxide film can be stably reduced, thereby enabling the thinning of the thermal oxide film.

In this case, it is preferable that the single-crystal silicon wafer is heated to a temperature of 800°C or more and 1250°C or less to thin the thermal oxide film. Within such a temperature range, it is possible to reliably reduce the portion of the oxide film and perform thinning of the thermal oxide film. Moreover, it is preferable to perform thinning by maintaining the temperature within this range for 1 second or more and 5 minutes or less. The temperature and time can be adjusted according to the thickness of the thermal oxide film.

Moreover, the thinning of the thermal oxide film can be performed by plasma using a gas containing a hydrogen atom or by plasma using an inert gas. When the plasma using the gas containing the hydrogen atom is employed, a portion of the oxide film can be stably reduced at a low temperature, thereby enabling more effective and stable thinning of the thermal oxide film. Furthermore, when the plasma using the inert gas is employed, by sputtering the oxide film with high-energy particles generated by the plasma, the thermal oxide film can be thinned more effectively and stably.

Examples of such gases, which can be used, include a hydrogen molecule, ammonia, nitrogen, argon, helium, neon, krypton, and xenon. These gases can be mixed for use. In the case of the hydrogen molecule and ammonia, which are gases containing the hydrogen atom, the oxide film can be etched by a hydrogen radical generated by plasma. In the case of inert gases such as nitrogen, argon, helium, neon, krypton, and xenon, the oxide film can be etched by sputtering with high-energy particles generated by plasma.

Note that when thinning the oxide film using the plasma as described above, the thinning may be performed at room temperature or may be performed by heating at 500°C or less. The time of exposing the wafer to the plasma depends on the oxide film thickness, plasma density, ion energy, and the like; however, by setting the time to, for example, 1 second or more and 30 minutes or less, the stable thinning is achieved.

Moreover, in Step S15, namely the step of epitaxially growing, in order to thin the thermal oxide film to a thickness sufficient for epitaxial growth, a value of the oxide film thickness obtained as a result of performing a spectroscopic ellipsometry measurement on the single-crystal silicon wafer from which the native oxide film has been removed is defined as "α" (nm), and a value of the oxide film thickness measured by spectroscopic ellipsometry after thinning of the thermal oxide film can be set to more than the "α" and α+0.5 (nm) [10α+5 (Å)] or less.

When the film thickness is within such a range, it is possible to stably prevent the epitaxial layer from becoming polycrystalline or amorphous. Accordingly, single-crystal silicon can be epitaxially grown on the oxygen-atom layer stably and reliably.

Moreover, it is preferable that the planar density of oxygen in the oxygen-atom layer be 1×10¹⁵ atoms/cm² or less. When the oxygen-atom layer having the planar density of oxygen in such a range is employed, it is possible to obtain the single-crystal silicon layer with greater stability, fewer stacking faults, fewer dislocations, and high crystallinity through epitaxial growth. Note that the lower limit of the planar density of oxygen is not limited and may only be greater than 0. Note that in order to stably obtain a gettering capability, the planar density is preferably 1×10¹³ atoms/cm² or more.

Step S15 in FIG. 1 is the step of, after thinning the thermal oxide film in Step S14, epitaxially growing single-crystal silicon to form an epitaxial wafer in which the single-crystal silicon layer is formed on the single-crystal silicon wafer via the oxygen-atom layer.

As for a gas used for epitaxial growth, for example, monosilane and disilane can be used. Nitrogen and hydrogen may be used as a carrier gas. Moreover, chamber pressure may be a pressure at which Si powders are not generated in the vapor phase.

As for an epitaxial growth apparatus, either a batch apparatus or a single-wafer apparatus may be employed.

Moreover, the epitaxial growth of the single-crystal silicon can be performed at a temperature of, for example, 450°C or more and 800°C or less. By performing the epitaxial growth within such a temperature range, it is possible to prevent the formation of the dislocation and the stacking fault in the epitaxial layer to be formed, thereby forming a high-quality epitaxial layer more stably. Furthermore, within such a temperature range, oxygen diffusion from the oxygen atom layer can be more reliably prevented, thereby preventing the disappearance of the oxygen atom layer.

As the epitaxial growth rate increases with temperature being higher, the film formation at a high temperature enables the formation of a thick epitaxial layer in a short time. On the other hand, when the formation of a thin epitaxial layer is desired, the formation may be performed at a low temperature. In this way, the growth temperature can be varied according to the intended thickness of the epitaxial layer.

Moreover, the formation time can be adjusted to adjust the epitaxial layer thickness. When forming at a high temperature, by shortening the formation time, it is possible to prevent degradation in the heat resistance of the oxygen-atom layer due to outward diffusion of oxygen from the single-crystal silicon wafer.

The epitaxial growth of the single-crystal silicon can also be, for example, performed at a partial pressure of a silicon raw material gas at 0.1 Pa or more and 2000 Pa or less. Within such a pressure range, the single-crystal silicon can be more stably formed on the oxygen-atom layer without generating the dislocation or the stacking fault.

By performing Steps S11 to S15 as shown above, it is possible to obtain, for example, the epitaxial wafer 10A shown in FIG. 2.

According to the studies by the present inventors, as described above, by forming the oxide film on the single-crystal silicon wafer 1, and then thinning the oxide film, subsequently epitaxially growing the single-crystal silicon, the oxygen-atom layer 2 having a uniform oxygen density on the wafer surface can be formed. This is considered to be because the oxidation rate in the single-crystal silicon decreases as the oxide film grows, and therefore it is easier to control the film thickness by forming the oxide film thicker than the intended thickness and then thinning, rather than adjusting the formation of the oxide film such that the thickness of the oxygen-atom layer 2 reaches the intended thickness. In addition, thinning of the oxide film progresses more slowly than oxidation, thereby enabling better controllability.

Moreover, depending on the intended end, by CMP processing on the surface of the wafer after Step S15 of epitaxially growing, defects and roughness on the surface thereof can be improved. In this case, by setting the machining allowance in the CMP processing to be smaller than the thickness of the silicon layer formed by epitaxial growth, the silicon layer can be retained, thereby enabling the production of the epitaxial wafer having the oxygen-atom layer.

Following Step S15 of epitaxially growing single-crystal silicon, Step S13 of forming a thermal oxide film, Step S14 of thinning the thermal oxide film, and Step S15 of epitaxially growing single-crystal silicon are repeatedly performed; accordingly, as shown in FIG. 3, for example, the plurality of oxygen-atom layers 2 can be formed. That is, according to the method for manufacturing an epitaxial wafer in this embodiment, an epitaxial wafer 10B shown in FIG. 3 can be obtained in which the oxygen-atom layer 2 and the single-crystal silicon layer 3 are alternately and repeatedly stacked on the single-crystal silicon wafer 1. An uppermost surface of the epitaxial wafer 10B in FIG. 3 is the single-crystal silicon layer 3.

In this way, by providing the oxygen-atom layer 2 as a plurality of layers, the gettering effect can be enhanced compared to that of the case where the oxygen-atom layer 2 as a single layer is formed.

Note that when the oxygen-atom layer 2 is formed as a plurality of layers, before the second and subsequent Step S13 of forming a thermal oxide film, Step S12 of removing a native oxide film may be included or may be omitted.

Moreover, when the oxygen-atom layer 2 is formed as a plurality of layers, by setting the maximum temperature to 1050°C or less at the second and subsequent formation of the thermal oxide film or thinning of the thermal oxide film, it is possible to more reliably prevent the diffusion of oxygen from the oxygen-atom layer and resulting elimination of the oxygen-atom layer.

According to the inventive method for manufacturing an epitaxial wafer described above, the specialized apparatus is not required, and the method is highly versatile, while enabling stable and easy formation of the oxygen-atom layer for proximity gettering and formation of a high-quality epitaxial layer; accordingly, a high-quality epitaxial wafer can be obtained.

### EXAMPLES

Hereinafter, the present invention will be specifically described with reference to Example. However, the present invention is not limited thereto.

### [Example 1 and Comparative Example 1]

The conductivity type, diameter, crystal plane orientation, and oxygen concentration of a single-crystal silicon wafer, which was provided, were as follows.
Conductivity type: p-type
Diameter: 300 mm
Crystal plane orientation: (100)
Oxygen concentration: 14 ppma (JEITA)

Next, in order to remove a native oxide film from a surface of the provided single-crystal silicon wafer, the single-crystal silicon wafer was transferred into an RTA apparatus, a temperature therein was set to 1100°C, and the single-crystal silicon wafer was heated in a hydrogen atmosphere for 30 seconds.

Subsequently, after purging a chamber of the RTA apparatus with nitrogen, the single-crystal silicon wafer was heated at a temperature of 900°C for 16 seconds in an oxygen-containing atmosphere to form a thermal oxide film on the wafer surface.

Thereafter, a measurement result of the film thickness of the thermal oxide film by spectroscopic ellipsometry was 1 nm (10 Å). Prior to this measurement, when the single-crystal silicon wafer was transferred to the RTA apparatus and heated at a temperature of 1100°C in a hydrogen atmosphere for 30 seconds, a measurement result of the oxide film thickness by spectroscopic ellipsometry indicated that a value "α" of the oxide film thickness obtained by the spectroscopic ellipsometry measurement was determined to be 0.2 nm (2 Å) when the oxide film was absent. Accordingly, when subtracting the value "α" of the oxide film thickness from the measured thickness of the thermal oxide film, the resulting thermal oxide film thickness was 0.8 nm (8 Å), which is an actual film thickness of the thermal oxide film.

Subsequently, in Example 1, the wafer on which the thermal oxide film had been formed was transferred into a film-forming apparatus and heated in a hydrogen atmosphere to thin the thermal oxide film. A heat-treatment temperature at this time was set to 900°C for durations of 111, 116, 120, 124, 127, 130, and 133 seconds.

FIG. 4 shows the results of the measurement of the oxide film by spectroscopic ellipsometry after thinning. By subtracting the value "α" of the oxide film thickness from the measured results, the resulting values were 0.5 nm (5.0 Å), 0.44 nm (4.4 Å), 0.29 nm (2.9 Å), 0.18 nm (1.8 Å), 0.14 nm (1.4 Å), 0.06 nm (0.6 Å), 0.05 nm (0.5 Å), in sequence. In all cases, the oxide film thickness was measured at 9 points across the wafer surface, and a variation in the oxide film thickness was 0.02 nm (0.2 Å) or less.

In Comparative Example 1, thinning of an oxide film by heating in a hydrogen atmosphere was not performed. That is, a heating time in the hydrogen atmosphere in Comparative Example 1 was 0 seconds.

Subsequently, single-crystal silicon was epitaxially grown on the surfaces of the single-crystal silicon wafers in Example 1 and Comparative Example 1 using monosilane. A temperature was set to 700°C, a partial pressure of monosilane was set to 60 Pa, and a film thickness was set to 100 nm. At this time, hydrogen was used as a carrier gas. Accordingly, epitaxial wafers were manufactured in each of Example 1 and Comparative Example 1.

Note that, in Example 1, the thinning of the thermal oxide film and the epitaxial growth of single-crystal silicon were performed in the same chamber.

On the other hand, in Comparative Example 1, as described above, single-crystal silicon was epitaxially grown without thinning the oxide film by heating in a hydrogen atmosphere.

As a result of performing a cross-sectional TEM observation after the film formation, in the case where thinning was not performed in Comparative Example 1, the formed layer was polycrystalline. In contrast, in the case where the thermal oxide film was formed and thinned in Example 1, the formed layer was single-crystal silicon in all instances.

### [Comparative Example 2]

In Comparative Example 2, first, a same single-crystal silicon substrate as in Example 1 was provided. Next, in order to remove a native oxide film from a surface of the provided single-crystal silicon wafer, the single-crystal silicon wafer was subjected to hydrofluoric acid cleaning in a batch cleaning apparatus, followed by pure wafer rinsing, and then heated in a hydrogen atmosphere. A heating temperature was set to 1150°C, with a duration of 1 minute.

Subsequently, by leaving the single-crystal silicon wafer in the atmosphere for 5 hours, the surface of the single-crystal silicon wafer was oxidized to form an oxygen-atom layer.

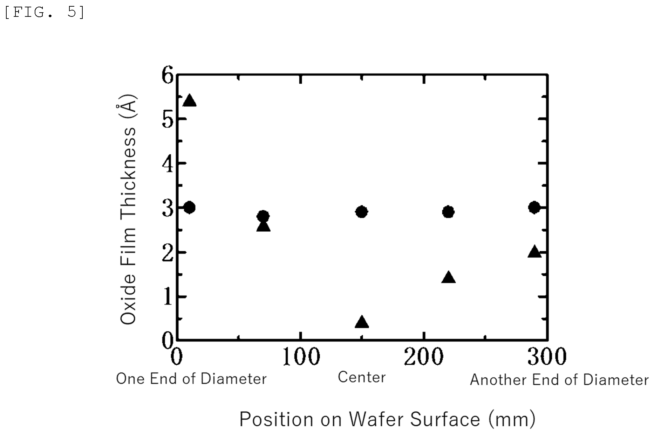

FIG. 5 shows (▲), as a result of measurements of an oxide film thickness at 5 points on the wafer surface using spectroscopic ellipsometry after forming the oxygen-atom layer. Moreover, FIG. 5 shows (•), as a result of measurements of an oxide film thickness at 5 points in the wafer surface using spectroscopic ellipsometry after thinning in a hydrogen atmosphere for a thinning duration of 120 seconds in Example 1.

As shown in FIG. 5, in Comparative Example 2, in which the oxygen-atom layer was formed by leaving the wafer in the atmosphere, the oxide film thickness was non-uniform. That is, the oxygen density became non-uniform across the wafer surface. This is caused by a higher oxidation rate at an outer peripheral portion of the wafer than at a central portion. A possible cause of the variation in the oxidation rate across the wafer surface is a change in air flow velocity. A higher air flow velocity increases the amount of supplied oxygen, thereby increasing the oxidation rate of silicon. According to the above results, it is considered that by flow velocity distribution in which the air flow velocity was increased from the wafer central portion toward the outer periphery portion, the oxygen density varied across the wafer surface.

As described above, in Example 1, which is an example of the present invention, compared with Comparative Example 2, in which neither the thermal oxide film formation by heating in a hydrogen atmosphere nor the thinning of the oxide film was performed, the oxygen-atom layer was successfully introduced into the epitaxial layer stably and easily. In addition, compared with Comparative Example 2, and Comparative Example 1 in which the thinning of the oxide film was not performed, the epitaxial wafer having a silicon epitaxial layer composed of high-quality single-crystal silicon was successfully manufactured.

The present description includes the following embodiments.
[1]: A method for manufacturing an epitaxial wafer by forming a single-crystal silicon layer on a single-crystal silicon wafer via an oxygen-atom layer, the method comprising the steps of:
   removing a native oxide film from a surface of the single-crystal silicon wafer;
   forming a thermal oxide film on the surface of the single-crystal silicon wafer from which the native oxide film has been removed;
   thinning the thermal oxide film; and
   after thinning the thermal oxide film, epitaxially growing single-crystal silicon to form an epitaxial wafer in which the single-crystal silicon layer is formed on the single-crystal silicon wafer via the oxygen-atom layer.
[2]: The method for manufacturing an epitaxial wafer according to the above [1], wherein
   the removal of the native oxide film is performed with a solution containing hydrofluoric acid.
[3]: The method for manufacturing an epitaxial wafer according to the above [1] or [2], wherein
   the thermal oxide film is formed by heat treatment in an oxygen-containing atmosphere at a temperature of 600°C or more and 1200°C or less.
[4]: The method for manufacturing an epitaxial wafer according to the above [1], [2], or [3], wherein
   a value of an oxide film thickness obtained as a result of performing a spectroscopic ellipsometry measurement on the single-crystal silicon wafer from which the native oxide film has been removed is defined as "α", and a thickness of the thermal oxide film is a thickness more than α+0.5 (nm).
[5]: The method for manufacturing an epitaxial wafer according to the above [1], [2], [3], or [4], wherein
   the removal of the native oxide film and the thinning of the thermal oxide film are performed by heating the single-crystal silicon wafer in a hydrogen atmosphere.
[6]: The method for manufacturing an epitaxial wafer according to the above [5], wherein
   a temperature of the heating in the hydrogen atmosphere is 800°C or more and 1250°C or less.
[7]: The method for manufacturing an epitaxial wafer according to the above [1], [2], [3], or [4], wherein
   the removal of the native oxide film and the thinning of the thermal oxide film are performed with plasma using a gas containing a hydrogen atom or with plasma using an inert gas.
[8]: The method for manufacturing an epitaxial wafer according to the above [1], [2], [3], [4], [5], [6], or [7], wherein
   a value of an oxide film thickness obtained as a result of performing a spectroscopic ellipsometry measurement on the single-crystal silicon wafer from which the native oxide film has been removed is defined as "α", and in the step of thinning the thermal oxide film, a value of the oxide film thickness measured by spectroscopic ellipsometry after thinning is more than the "α" and α+0.5 (nm) or less.
[9]: The method for manufacturing an epitaxial wafer according to the above [1], [2], [3], [4], [5], [6], [7], or [8], wherein
   in the step of epitaxially growing single-crystal silicon, the single-crystal silicon is epitaxially grown at a temperature of 450°C or more and 800°C or less.
[10]: The method for manufacturing an epitaxial wafer according to the above [1], [2], [3], [4], [5], [6], [7], [8], or [9], wherein
   after the step of epitaxially growing, CMP processing is performed.
[11]: The method for manufacturing an epitaxial wafer according to the above [1], [2], [3], [4], [5], [6], [7], [8], or [9], wherein
   following the step of epitaxially growing single-crystal silicon, the step of forming a thermal oxide film, the step of thinning the thermal oxide film, and the step of epitaxially growing single-crystal silicon are repeatedly performed.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing an epitaxial wafer by forming a single-crystal silicon layer on a single-crystal silicon wafer via an oxygen-atom layer, the method comprising the steps of:
removing a native oxide film from a surface of the single-crystal silicon wafer;
forming a thermal oxide film on the surface of the single-crystal silicon wafer from which the native oxide film has been removed;
thinning the thermal oxide film; and
after thinning the thermal oxide film, epitaxially growing single-crystal silicon to form an epitaxial wafer in which the single-crystal silicon layer is formed on the single-crystal silicon wafer via the oxygen-atom layer.

2. The method for manufacturing an epitaxial wafer according to claim 1, wherein
the removal of the native oxide film is performed with a solution containing hydrofluoric acid.

3. The method for manufacturing an epitaxial wafer according to claim 1, wherein
the thermal oxide film is formed by heat treatment in an oxygen-containing atmosphere at a temperature of 600°C or more and 1200°C or less.

4. The method for manufacturing an epitaxial wafer according to claim 1, wherein
a value of an oxide film thickness obtained as a result of performing a spectroscopic ellipsometry measurement on the single-crystal silicon wafer from which the native oxide film has been removed is defined as "α", and a thickness of the thermal oxide film is a thickness more than α+0.5 (nm).

5. The method for manufacturing an epitaxial wafer according to claim 1, wherein
the removal of the native oxide film and the thinning of the thermal oxide film are performed by heating the single-crystal silicon wafer in a hydrogen atmosphere.

6. The method for manufacturing an epitaxial wafer according to claim 5, wherein
a temperature of the heating in the hydrogen atmosphere is 800°C or more and 1250°C or less.

7. The method for manufacturing an epitaxial wafer according to claim 1, wherein
the removal of the native oxide film and the thinning of the thermal oxide film are performed with plasma using a gas containing a hydrogen atom or with plasma using an inert gas.

8. The method for manufacturing an epitaxial wafer according to claim 1, wherein
a value of an oxide film thickness obtained as a result of performing a spectroscopic ellipsometry measurement on the single-crystal silicon wafer from which the native oxide film has been removed is defined as "α", and in the step of thinning the thermal oxide film, a value of the oxide film thickness measured by spectroscopic ellipsometry after thinning is more than the "α" and α+0.5 (nm) or less.

9. The method for manufacturing an epitaxial wafer according to claim 1, wherein
in the step of epitaxially growing single-crystal silicon, the single-crystal silicon is epitaxially grown at a temperature of 450°C or more and 800°C or less.

10. The method for manufacturing an epitaxial wafer according to claim 1, wherein
after the step of epitaxially growing, CMP processing is performed.

11. The method for manufacturing an epitaxial wafer according to any one of claims 1 to 9, wherein
following the step of epitaxially growing single-crystal silicon, the step of forming a thermal oxide film, the step of thinning the thermal oxide film, and the step of epitaxially growing single-crystal silicon are repeatedly performed.
